# EUROPÄISCHE PATENTSCHRIFT

(11) **EP 0 784 545 B1**
(45) Veröffentlichungstag und Bekanntmachung des Hinweises auf die Patenterteilung: **08.11.2000**
(21) Anmeldenummer: 96929221.8
(22) Anmeldetag: 07.08.1996
(51) Int. Cl.: B44C 1/165, B44C 1/17, B42D 15/10

(54) **MEHRLAGIGES MATERIAL, INSBESONDERE TRANSFERBAND**
MULTILAYER MATERIAL, IN PARTICULAR TRANSFER STRIP
MATERIAU A COUCHES MULTIPLES, NOTAMMENT BANDE DE TRANSFERT

(30) Priorität: 08.08.1995 DE 19529171
(43) Veröffentlichungstag der Anmeldung: 23.07.1997
(73) Patentinhaber: Giesecke & Devrient GmbH, 81677 München (DE)
(72) Erfinder: WITTICH, Kaule, D-82275 Emmering (DE); GRAUVOGL, Gregor, D-80331 München (DE)
(74) Vertreter: Klunker . Schmitt-Nilson . Hirsch
(86) Internationale Anmeldenummer: EP9603500
(87) Internationale Veröffentlichungsnummer: WO9706017

(56) Entgegenhaltungen:
- DE-U- 9 217 061
- US-A- 4 455 181
- US-A- 5 322 975

## Beschreibung

Die Erfindung betrifft ein mehrlagiges Transfermaterial, bestehend aus einem Trägermaterial und einer ein- oder mehrlagigen, eine optisch variierende Struktur enthaltende Transferschicht sowie einer zwischen dem Trägerband und der Transferschicht liegenden Zwischenschicht sowie ein Verfahren zur Herstellung dieses Materials.

Bei Banknoten, Ausweiskarten, Pässen oder ähnlichen Dokumenten ist es erforderlich, Maßnahmen zu ergreifen, welche die Sicherheit erhöhen. Der Schutz vor Nachahmung kann deutlich erhöht werden, wenn diese Dokumente mit Transferelementen ausgestattet werden, die ein Hologramm, Beugungsgitter oder einen anderen mit dem Betrachtungswinkel variierenden Effekt aufweisen. Hierzu ist bereits bekannt, Hologramme im Transferverfahren auf Karten, Banknoten oder andere Dokumente aufzubringen, die einem hohen Sicherheitsstandard gerecht werden müssen.

Der Transfer des optisch variierenden Elements, wie beispielsweise eines Hologrammes, erfolgt üblicherweise so, daß es von einem Transferband unter Anwendung von Druck und Hitze übertragen wird. Die Transferbänder zum Übertragen von Hologrammen bestehen dabei aus einer Trägerfolie, einer hitzeaktivierbaren Releaseschicht, einer thermoplastischen Lackschicht mit holografischer Prägung, einer Aluminiumbedampfung, einer Schutzschicht und einer Heißkleberschicht. Beim Übertragen des Transferhologrammes auf das Substrat wird die thermoplastische Lackschicht einschließlich der folgenden Schichten mit Hilfe der Heißkleberschicht auf das Substrat übertragen, während die Trägerfolie zusammen mit der thermisch aktivierbaren Releaseschicht beim Übertragungsvorgang entfernt werden.

Für viele Anwendungen hat es sich bewährt, statt der thermoplastischen Lackschicht einen Lack zu verwenden, der mit Hilfe von Strahlung aushärtet.

Diese Lacke haben den Vorteil, daß sie beim Übertragen auf ein Substrat thermisch nicht verformbar sind. Oftmals werden sogenannte verzögernd härtende Lacke verwendet, bei denen die Aushärtung z.B. durch UV-Strahlung initiiert wird. Die Aushärtung tritt jedoch erst nach einer bestimmten Verzögerungszeit ein. Dadurch läßt sich der Lack unmittelbar vor dem Prägen bestrahlen, behält während des Prägevorganges die erforderliche Formbarkeit bei und härtet unmittelbar nach dem Prägen ohne weitere Verfahrensschritte selbständig irreversibel aus. Da bei dieser Verfahrensweise jedoch durch die Bestrahlung und die damit entstehende hohe Wärmeeinwirkung auch die Releaseschicht aktiviert werden kann, besteht die große Gefahr, daß sich die Trägerschicht von der Transferschicht bereits beim Einprägen der Beugungsstruktur in die Lackschicht vorzeitig löst. Bei dieser Vorgehensweise wird daher auf eine Releaseschicht meist völlig verzichtet. Releaseschichten haben jedoch die Aufgabe, das Ablösen des Transferelementes vom Träger zu erleichtern, wenn das Transferelement auf ein Substrat übertragen wird. Sofern auf eine Releaseschicht verzichtet wird, muß die dem Transferband nun fehlende Eigenschaft anderweitig erreicht werden. Beispielsweise lassen sich die Eigenschaften der Releaseschicht in die Prägelackschicht integrieren.

In der EP 0 502 111 B1 ist hierzu ein Lack beschrieben, dessen Eigenschaften derart modifiziert sind, so daß ein Prägen der Lackschicht gut möglich ist ohne daß sich der Lack vom Träger löst, der Lack jedoch gleichzeitig von der Transferfolie leicht ablösbar ist, wenn das Element auf ein Substrat übertragen wird.

Da die Haftung der Lackschicht an der Trägerfolie wesentlich von der Art und Vorbehandlung der Folie abhängt, wird die Lackschicht durch Zugabe von Zusatzstoffen an die jeweils als Trägerschicht verwendete Kunststoffolie angepaßt.

Dies bedeutet, daß die Prägelackschicht und die Trägerschicht jeweils so aufeinander abgestimmt werden müssen, daß die beschriebenen, nur schwer miteinander zu vereinbarenden Bedingungen erfüllt sind.

Darüber hinaus sind die Haftungswerte der Lackschicht am Träger selbst bei Verwendung gleicher Trägermaterialien oftmals nicht konstant. Die Eigenschaften der Trägerfolie unterliegen zufallsbedingten Schwankungen, deren Ursache z.B. in Schwankungen der Herstellungsbedingungen, Lagerzeit, Alterung oder ähnlichem liegen kann. Dies führt zu unterschiedlichen Haftungswerten der Trägerfolienoberfläche, so daß eine Anpassung der Haftung der Prägelackschicht an den verwendeten Träger selbst bei Verwendung der gleichen Trägerkunststofffolie nötig ist.

Die Aufgabe der Erfindung besteht daher darin, ein Transferband mit einem Trägerband und einer Transferschicht sowie ein Verfahren zu seiner Herstellung vorzuschlagen, wobei das Trägerband zur Transferschicht eine definierte Haftung aufweist.

Diese Aufgabe wird durch die Merkmale der unabhängigen Ansprüche gelöst. Besondere Ausführungsformen sind Gegenstand der Unteransprüche.

Der Grundgedanke der Erfindung besteht darin, durch eine Vorbehandlung des Trägerbandes eine definierte Haftung des Trägerbandes zur Transferschicht zu schaffen. Hierzu wird das Trägerband mit einer dünnen Metall- oder Halbleiteroxidschicht versehen, auf welche anschließend die Transferschicht aufgebracht wird.

Besonders vorteilhaft an der erfindungsgemäßen Lösung ist die Tatsache, daß durch das Aufbringen der dünnen Oxidschicht die Haftung der Trägerschicht an der Transferschicht von den Oberflächeneigenschaften der Trägerschicht entkoppelt werden. Somit kann die Transferschicht nahezu unabhängig von den Eigenschaften des Trägerbandes gewählt werden, ohne daß die gewünschten Haftungswerte negativ beeinflußt würden. Dies ist selbstverständlich auch bei Trägerbändern aus Kunststoff der Fall, die aus dem gleichen Kunststoffmaterial bestehen, jedoch aus unterschiedlichen Herstellungschargen stammen. Das Aufbringen einer Metall- oder Halbleiteroxidschicht auf das Trägerband schafft jeweils definierte Haftungsverhältnisse zur darüberliegenden Transferschicht. Der jeweils erzielte Haftungswert ist somit lediglich durch die Haftung der Transferschicht zur Oxidschicht bestimmt, der zwischen 15 und 50 mN/m, vorzugsweise zwischen 30 und 38 mN/m liegt.

Obwohl für das Trägerband viele Materialien, wie Kunststoff, Papier oder Silikonpapier, verwendet werden kann, wird in einer bevorzugten Ausführungsform eine Trägerfolie, beispielsweise eine Polyethylenterephthalatfolie, mit einer Siliziumoxidschicht (SiOₓ) bedampft. Da sich bei diesem Prozeß ein Gemisch aus SiO und SiO₂ auf der Trägerfolie ablagert, entsteht auf der Trägerfolie eine SiOₓ-Schicht mit 1 < x < 2. Die Dicke der Schicht wird dabei so gewählt, daß zwar einerseits eine durchgehende Flächenbelegung der Trägerfolie entsteht, jedoch andererseits die aufgedampfte Schicht transparent bleibt. Die Siliziumoxidschicht wird im Anschluß daran mit einem Prägelack beschichtet, in welchem in einem weiteren Arbeitsgang die gewünschte Hologrammstruktur z.B. mit Hilfe einer Prägewalze eingebracht wird. Nach dem Härten bzw. Vernetzen des Prägelackes wird die Seite, welche die Hologrammstruktur trägt, mit einer Metallschicht versehen. Auf die Metallschicht kann optional ein Reaktionskleber aufgebracht werden.

Die Siliziumoxidschicht stellt den Haftungswert des Transferhologramms zum Trägermaterial gerade so ein, daß das Hologramm in die Prägelackschicht eingebracht werden kann, ohne daß sich die Transferschicht dabei vom Träger löst. Demnach läßt sich das Hologramm beispielsweise mit einem Stempel oder einer Andruckrolle leicht auf ein Substrat übertragen und von der Trägerfolie leicht ablö-sen.

Weitere Vorteile und Verfahrensvarianten werden anhand der nachstehenden Figuren erläutert. Es wird darauf hingewiesen, daß die Figuren keine maßstabsgetreuen Darstellungen der Erfindung bieten, sondern lediglich der Veranschaulichung dienen sollen.

Es zeigen:
- Fig. 1:: Ein mit einem erfindungsgemäßen Sicherheitselement ausgestattetes Dokument,
- Fig. 2:: Grundprinzip der erfindungsgemäßen Folienvorbehandlung,
- Fig. 3:: Aufbau einer erfindungsgemäßen Transferfolie.

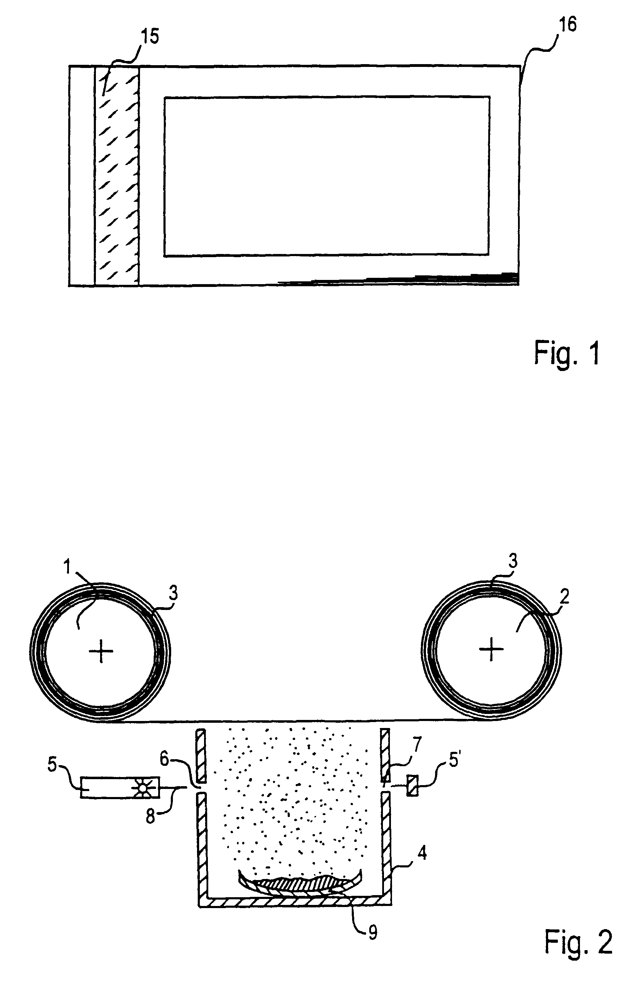

Wie in Fig. 1 dargestellt, ist es mit der erfindungsgemäßen Transferfolie möglich, das Transferelement 15 auf einen Datenträger, im vorliegenden Fall auf eine Banknote 16 zu übertragen. Das optisch variable Element 15 ist dabei insbesondere als Hologramm ausgeführt und kann so auf den Datenträger aufgebracht werden, daß es von einer Seitenkante bis zur gegenüberliegenden Seitenkante des Datenträgers reicht. Daneben sind auch noch sogenannte Insellösungen möglich, bei denen das optisch variable Element 15 als separates Element an einer beliebigen Stelle des Datenträgers aufgebracht werden kann. Auch hinsichtlich Form und Größe des optisch variablen Elementes bestehen keinerlei Beschränkungen, so daß das Element ohne Schwierigkeiten an das jeweils gewünschte Design des Datenträgers angepaßt werden kann.

Fig. 2 zeigt schematisch das Grundprinzip der erfindungsgemäßen Folienvorbehandlung zur Herstellung einer Transferfolie. Die Trägerfolie 3 ist auf einer Rolle 2 aufgewickelt und wird über einer Bedampfungsstation 4 zu einer zweiten Rolle 1 geführt, auf der die Folie nach dem Aufbringen der Metall- oder Halbleiteroxidschicht wieder aufgerollt wird. Als Trägerfolien können beispielsweise Polyethylenterephthalat (PET) orientiertes Polypropylen (OPP), orientiertes Polyamid (OPA) oder eine andere hinreichend stabile Folie verwendet werden. In der Bedampfungsstation 4 wird das aufzubringende Metall- oder Halbleiteroxid, beispielsweise das Siliziummonoxid in einem beheizbaren Tiegel erhitzt und verdampft. Das zu verdampfende SiO liegt im Tiegel als braunes Pulver vor. Die in die Dampfphase übergehenden Partikel schlagen sich auf der Oberfläche der Trägerfolie nieder und bilden einen dünnen Film, dessen Dicke von der Transportgeschwindigkeit der Trägerfolie sowie der Verdampfungstemperatur abhängt. Obwohl das Verdampfen unter Vakuum erfolgt, wird an der Folienbahn keine reine Siliziummonoxidschicht abgelagert. Denn aus der vorhandenen Restluft reagiert Sauerstoff mit SiO zu SiO₂, so daß an der Oberfläche der Folienbahn eine Lage aus einem Gemisch von SiO und SiO₂, die sogenannte SiOₓ-Schicht, angelagert wird. Auch an der Oberfläche der Folie gebundener Sauerstoff leistet einen Beitrag zur Bildung von SiO₂. Je nach aufzubringender Oxidschicht werden die Prozeßparameter so gewählt, daß Schichten in einer Dicke von nicht mehr als 200 nm, bevorzugt in einer Dicke von 60 bis 100 nm, aufgebracht werden. Diese dünnen Schichten haben den Vorteil, daß sie einerseits bereits eine ausreichend definierte Haftungsfläche zur später aufzubringenden Lackschicht bilden und andererseits transparent sind. Sie beeinflußt daher den optischen Eindruck nicht, der vom Transferelement erreicht werden soll. Im Gegensatz zur Verdampfung von Aluminium liegen die Verdampfungstemperaturen von Siliziumoxid relativ hoch, d.h. im allgemeinen zwischen 1350 und 1400° C, so daß es erforderlich ist, die Rollen 1 und 2 während des Aufdampfen des Oxides zu kühlen.

Die Abscheidungsrate der Oxidschicht läßt sich beispielsweise dadurch kontrollieren, daß in der Verdampfungsstation Fenster 6 und 7 vorgesehen werden. Durch das Fenster 6 wird von einer Lichtquelle 5 ein Lichtstrahl 8 einer Intensität I₀ in das Innere der Verdampfungsstation 4 geleitet. Je nach Menge der durch die Verdampfung aufsteigenden Partikel wird der einfallende Lichtstrahl mehr oder weniger stark diffus gestreut, so daß die Intensität I₀ um einen bestimmten Betrag erniedrigt wird. Die aus dem Fenster 7 austretende Intensität I₁ bzw. der Quotient I₁/I₀ stellen ein direktes Maß für die Verdampfungsrate dar, die dann entsprechend den jeweiligen Erfordernissen geregelt werden kann.

Statt der in der Fig. 2 gezeigten Verdampfungsstation 4 kann die Metall- oder Halbleiteroxidschicht, auch durch andere Verfahrenstechniken, wie durch eine chemische Abscheidung, aus der Dampfphase auf dem Trägermaterial abgelagert werden. Die Verdampfungsstation 4 kann auch als Elektronenstrahlbeschichtungsstation ausgeführt werden, bei der ein Elektronenstrahl als Heizquelle benutzt wird. Der im Prinzip punktförmige Elektronenstrahl wird dabei in Querrichtung schnell über einen Verdampfungstiegel 9 geführt, welcher das zu verdampfende Oxidmaterial enthält. Die Elektronenstrahlbeschichtung hat den Vorteil, daß mit dieser Technik eine Beschichtung auch breiter Bahnen möglich wird und die Bahngeschwindigkeit gesteigert werden kann.

Nach dem Beschichten der Trägerfolie mit der dünnen SiOₓ-Schicht wird in einem weiteren Arbeitsgang auf diese SiOₓ-Schicht die ein- oder mehrschichtige Transferschicht aufgebracht. Bei der Herstellung von Hologrammtransferschichten wird hierzu eine Prägelackschicht auf die SiOₓ-Schicht aufgetragen, in welche die jeweils gewünschte holografische Prägestruktur eingeprägt wird. Nach dem Aushärten bzw. Vernetzen der Prägelackschicht wird auf diese in einem weiteren Arbeitsgang eine Metallisierung aufgebracht, die den optischen Eindruck des Prägehologramms deutlich verstärkt. Sofern erforderlich, wird die Metallschicht mit einer Heißkleberschicht versehen, mit der das Transferelement unmittelbar auf ein Substrat geklebt werden kann. Auf diese Kleberschicht kann jedoch verzichtet werden, wenn unmittelbar vor dem Aufbringen des Transferelementes auf das Substrat eine geeignete Kleberschicht aufgebracht und das Transferelement auf die mit Kleber beschichteten Bereiche des Substrates übertragen wird. In solchen Fällen ist es günstig, solche Kleber zu verwenden, die verzögernd härten, d.h. also, deren Aushärtung nach dem Aufbringen beispielsweise durch eine UV-Lampe initiiert wird.

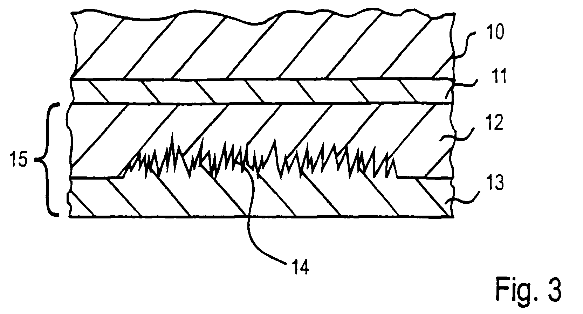

Der Aufbau des erfindungsgemäßen Transferbandes ist in Fig. 3 schematisch dargestellt. Auf einer Trägerfolie 10 ist eine dünne Halbleiter- oder Metalloxidschicht 11, beispielsweise eine SiOₓ-, Magnesiumoxid- oder Aluminiumoxidschicht aufgebracht. Auf dieser Oxidschicht befindet sich die auf das Substrat zu übertragende Transferschicht 15, die im vorliegenden Fall als mehrlagige Schicht ausgeführt ist. Die Transferschicht 15 besteht aus einer Lackschicht 12, in welche eine holografische Struktur 14 eingeprägt ist. Auf der Prägeseite der Lackschicht ist eine Metallschicht aufgebracht, die bevorzugt aufgedampft wird. Je nachdem, wie die Transferschicht auf das Substrat aufgebracht werden soll, wird eine weitere, in der Fig. 3 nicht gezeigte, Heißschmelzkleberschicht auf die Metallschicht 13 aufgebracht.

Der Haftungsverbund zwischen der Trägerfolie und der Transferschicht wird über die Oxidschicht 11 sehr genau und definiert eingestellt. Für eine Siliziumoxidschicht, die auf eine OPA-Folie aufgedampft wird, lassen sich die Haftungswerte zu einer auf der Oxidschicht aufgedruckten UV-Lackschicht im Bereich zwischen 15 bis 50 mN/m, bevorzugt von 30 mN/m bis 38 mN/m einstellen.

Die Erfindung ist jedoch nicht auf das Vorsehen einer bestimmten Transferschicht, beispielsweise eines Hologramms, beschränkt. Vielmehr können mit dem erfindungsgemäßen Transferband nahezu beliebige Schichten auf Substrate übertragen werden. Neben den bereits erwähnten Hologrammen können auch glatte metallische Flächen, magnetische Schichten oder Flächen mit Effektpigmenten auf Substrate, wie Papier, Kunststoff oder Metall, übertragen werden. Vom sicherheitstechnischen Standpunkt aus sind Schichten mit optisch erkennbaren oder optisch variablen sowie mit maschinenlesbaren Eigenschaften besonders interessant.

Anhand der nachfolgenden Beispiele soll die erfindungsgemäße Transferfolie weiter erläutert werden.

### Beispiel 1

Eine 25 µm OPA-Folie wird mit Siliziumoxid bedampft (0,1 g/m² bis 0,25 g/m²). Anschließend wird ein UV-vernetzbarer Lack in einer der gängigen Techniken, beispielsweise durch Bedrucken der Siliziumoxidschicht aufgebracht. Nach holografischer Prägung und UV-Härtung wird die Folie mit Aluminium bedampft. Nach der Applikation dieser Transferfolie mit einem Reaktionsklebstoff kann die OPA-Trägerfolie sehr leicht abgezogen werden, ohne daß Fehlstellen auf der zurückbleibenden Hologrammprägeschicht entstehen.

### Beispiel 2

Eine 25 µm OPA-Folie wird mit Siliziumoxid bedampft und mit einem thermoplastischem Lack beschichtet. Nach holografischer Prägung mit einer geheizten Prägewalze wird die Folie mit Aluminium bedampft. Auf die Aluminiumfolie wird ein Reaktionsklebstoff appliziert. Beim Übertragen der Transferschicht kann die OPA-Trägerfolie sehr leicht abgezogen werden, ohne daß Fehlstellen auf der Transferschicht zurückbleiben.

### Beispiel 3

Eine 25 µm OPA-Folie wird mit Siliziumoxid bedampft und mit einem kaltvernetzendem Lack beschichtet. Nach der Aushärtung des Lackes wird die Folie mit Kupfer bedampft. Mit Hilfe eines Reaktionsklebstoffes, der unmittelbar auf das Substrat aufgetragen wird, wird das Transferelement der Transferfolie auf das Substrat übertragen, wobei sich die OPA-Trägerfolie sehr leicht abziehen läßt. Auf diese Weise läßt sich auf dem Substrat eine goldglänzende Schicht erzeugen.

### Beispiel 4

Eine 12 µm PET-Folie wird mit Siliziumoxid bedampft und mit einem lösemittelhaltigem Lack beschichtet. Nach dem Trocknen des Lacks wird die Folie mit Aluminium bedampft. Die Applikation des Transferelementes erfolgt wie im Beispiel 3 durch Auftragen eines Reaktionsklebstoffes unmittelbar auf die Substratfläche, auf welche dann die Transferfolie aufgelegt und die Trägerfolie abgezogen wird. Hierdurch wird auf dem Substrat eine silbrigglänzende Schicht erzeugt.

## Patentansprüche

1. Mehrlagiges Transfermaterial, bestehend aus einem Trägerband und wenigstens einer Kunststoffschicht sowie einer zwischen dem Trägerband und der Kunststoffschicht liegenden Zwischenschicht, dadurch **gekennzeichnet,** daß die Zwischenschicht eine Metalloxid- oder eine Halbleiteroxidschicht ist.

2. Mehrlagiges Transfermaterial nach Anspruch 1, dadurch **gekennzeichnet,** daß das Transfermaterial eine Transferfolie ist.

3. Mehrlagiges Transfermaterial nach Anspruch 1 oder 2, dadurch **gekennzeichnet,** daß die Zwischenschicht eine Dicke von weniger als 200 nm, insbesondere zwischen 60 nm und 100 nm, aufweist.

4. Mehrlagiges Transfermaterial nach einem der Ansprüche 1 bis 3, dadurch **gekennzeichnet,** daß die Zwischenschicht eine Siliziumoxidschicht, insbesondere ein Gemisch aus Siliziumoxid und Siliziumdioxid ist.

5. Mehrlagiges Transfermaterial nach einem der Ansprüche 1 bis 4, dadurch **gekennzeichnet,** daß die Zwischenschicht transparent ist.

6. Mehrlagiges Transfermaterial nach einem der Ansprüche 1 bis 5, dadurch **gekennzeichnet,** daß der Haftungswert des Trägerbandes an der Kunststoffschicht 15 bis 50 mN/m beträgt.

7. Mehrlagiges Transfermaterial nach einem der Ansprüche 1 bis 6, dadurch **gekennzeichnet,** daß die Zwischenschicht thermisch aufgedampft, chemisch abgeschieden oder mit Hilfe von Elektronenstrahlen aufgedampft ist.

8. Mehrlagiges Transfermaterial nach einem der Ansprüche 1 bis 3, dadurch **gekennzeichnet,** daß die Zwischenschicht eine Aluminiumoxid- oder Magnesiumoxidschicht ist.

9. Mehrlagiges Transfermaterial nach einem der Ansprüche 1 bis 8, dadurch **gekennzeichnet,** daß das Transfermaterial zusätzlich eine Reaktionslackschicht aufweist, die mit einer holografischen Prägung versehen ist.

10. Mehrlagiges Transfermaterial nach einem der Ansprüche 1 bis 9, dadurch **gekennzeichnet,** daß das Transfermaterial eine metallische Fläche, magnetische Elemente oder Effektpigmente aufweist.

11. Verfahren zur Herstellung eines mehrschichtigen Transfermaterials, das ein Trägerband, wenigstens eine Kunststoffschicht sowie eine zwischen dem Trägerband und der Kunststoffschicht liegende Zwischenschicht aufweist, dadurch **gekennzeichnet,** daß auf eine Oberfläche des Trägerbandes eine Metall- oder Halbleiteroxidschicht als Zwischenschicht aufgebracht wird und auf diese Zwischenschicht die Kunststoffschicht aufgebracht wird.

12. Verfahren nach Anspruch 11, dadurch **gekennzeichnet,** daß die Zwischenschicht auf der Oberfläche des Trägerbandes thermisch aufgedampft, chemisch abgeschieden oder mit Hilfe von Elektronenstrahlen aufgedampft wird.

13. Verfahren nach Anspruch 11, dadurch **gekennzeichnet,** daß die Zwischenschicht durch Aufdampfen einer Siliziumoxid-, Magnesiumoxid- oder Aluminiumoxidschicht auf das Trägerband hergestellt wird.

14. Verfahren nach einem der Ansprüche 11 bis 13, dadurch **gekennzeichnet,** daß die Metall- oder Halbleiteroxidschicht in einer Dicke von nicht mehr als 200 nm, insbesondere zwischen 60 nm und 100 nm, aufgebracht wird.

15. Verwendung eines mehrlagigen Transfermaterials gemäß einem der Ansprüche 1 bis 10 zur Erzeugung von wenigstens einem Sicherheitselement auf einem Datenträger, wie Banknote, Ausweiskarte oder ähnlichem.

## Claims

1. A multilayer transfer material consisting of a carrier band and at least one plastic layer and an intermediate layer located between the carrier band and the plastic layer, characterized in that the intermediate layer is a metal oxide or semiconductor oxide layer.

2. A multilayer transfer material according to claim 1, characterized in that the transfer material is a transfer foil.

3. A multilayer transfer material according to claim 1 or 2, characterized in that the intermediate layer has a thickness of less than 200 nm, in particular between 60 nm and 100 nm.

4. A multilayer transfer material according to any of claims 1 to 3, characterized in that the intermediate layer is a silicon oxide layer, in particular a mixture of silicon oxide and silicon dioxide.

5. A multilayer transfer material according to any of claims 1 to 4, characterized in that the intermediate layer is transparent.

6. A multilayer transfer material according to any of claims 1 to 5, characterized in that the adhesion coefficient of the carrier foil on the transfer layer is 15 to 50 mN/m.

7. A multilayer transfer material according to any of claims 1 to 6, characterized in that the intermediate layer is thermally vaporized, chemically precipitated or vaporized with the help of electron beams.

8. A multilayer transfer material according to any of claims 1 to 3, characterized in that the intermediate layer is an aluminum oxide or magnesium oxide layer.

9. A multilayer transfer material according to any of claims 1 to 8, characterized in that the transfer material additionally has a reaction lacquer layer which is provided with a holographic embossing.

10. A multilayer transfer material according to any of claims 1 to 9, characterized in that the transfer material has a metallic surface, magnetic elements or effect pigments.

11. A method for producing a multilayer transfer material having a carrier band, at least one plastic layer and an intermediate layer located between the carrier band and the transfer layer, characterized in that a metal or semiconductor oxide layer is applied to one surface of the carrier band as an intermediate layer and the plastic layer is applied to said intermediate layer.

12. A method according to claim 11, characterized in that the intermediate layer is thermally vaporized, chemically precipitated or vaporized with the help of electron beams on the surface of the carrier band.

13. A method according to claim 11, characterized in that the intermediate layer is produced by vaporizing a silicon oxide, magnesium oxide or aluminum oxide layer on the carrier band.

14. A method according to any of claims 11 to 13, characterized in that the metal or semiconductor oxide layer is applied in a thickness of no more than 200 nm, in particular between 60 nm and 100 nm.

15. Use of a multilayer transfer material according to any of claims 1 to 10 for producing at least one security element on a data carrier such as a bank note, identity card or the like.

## Revendications

1. Matériau de transfert multicouche, constitué d'une bande support et d'au moins une couche de matière plastique ainsi que d'une couche intermédiaire située entre la bande support et la couche de matière plastique, caractérisé en ce que la couche intermédiaire est une couche d'oxyde métallique ou une couche d'oxyde semi-conducteur.

2. Matériau de transfert multicouche selon la revendication 1, caractérisé en ce que le matériau de transfert est une feuille de transfert.

3. Matériau de transfert multicouche selon la revendication 1 ou la revendication 2, caractérisé en ce que la couche intermédiaire présente une épaisseur de moins de 200 nm, en particulier entre 60 nm et 100 nm.

4. Matériau de transfert multicouche selon l'une des revendications 1 à 3, caractérisé en ce que la couche intermédiaire est une couche d'oxyde de silicium, en particulier un mélange d'oxyde de silicium et de dioxyde de silicium.

5. Matériau de transfert multicouche selon l'une des revendications 1 à 4, caractérisé en ce que la couche intermédiaire est transparente.

6. Matériau de transfert multicouche selon l'une des revendications 1 à 5, caractérisé en ce que le coefficient d'adhérence de la bande support sur la couche de matière plastique est de 15 à 50 mN/m.

7. Matériau de transfert multicouche selon l'une des revendications 1 à 6, caractérisé en ce que la couche intermédiaire est obtenue par dépôt thermique en phase vapeur, par précipitation chimique ou obtenue par dépôt en phase vapeur à l'aide de faisceaux d'électrons.

8. Matériau de transfert multicouche selon l'une des revendications 1 à 3, caractérisé en ce que la couche intermédiaire est une couche d'oxyde d'aluminium ou une couche d'oxyde de magnésium.

9. Matériau de transfert multicouche selon l'une des revendications 1 à 8, caractérisé en ce que le matériau de transfert présente en plus une couche de vernis réactionnel qui est muni d'une empreinte holographique.

10. Matériau de transfert multicouche selon l'une des revendications 1 à 9, caractérisé en ce que le matériau de transfert présente une surface métallique, des éléments magnétiques ou des pigments d'effet.

11. Procédé de fabrication d'un matériau de transfert multicouche qui présente une bande support, au moins une couche de matière plastique ainsi qu'une couche intermédiaire située entre la bande support et la couche de matière plastique, caractérisé en ce qu'une couche d'oxyde métallique ou une couche d'oxyde semi-conducteur est déposée en tant que couche intermédiaire sur une surface de la bande support et la couche de matière plastique est déposée sur cette couche intermédiaire.

12. Procédé selon la revendication 11, caractérisé en ce que la couche intermédiaire sur la surface de la bande support est obtenue par dépôt thermique en phase vapeur, précipitation chimique ou obtenue par dépôt en phase vapeur à l'aide de faisceaux d'électrons.

13. Procédé selon la revendication 11, caractérisé en ce que la couche intermédiaire est produite par dépôt par dépôt thermique en phase vapeur sur la bande support d'une couche d'oxyde de silicium, d'oxyde de magnésium ou d'oxyde d'aluminium.

14. Procédé selon l'une des revendications 11 à 13, caractérisé en ce que la couche d'oxyde métallique ou d'oxyde semi-conducteur est déposée sur une épaisseur non supérieure à 200 nm, en particulier de 60 nm à 100 nm.

15. Utilisation d'un matériau de transfert multicouche selon l'une des revendications 1 à 10 pour réaliser au moins un élément de sécurité sur un support de données tel qu'un billet de banque, une carte d'identité ou similaire.
